# EUROPÄISCHE PATENTSCHRIFT

(11) **EP 3 014 365 B1**
(45) Veröffentlichungstag und Bekanntmachung des Hinweises auf die Patenterteilung: **31.07.2019**
(21) Anmeldenummer: 14732171.5
(22) Anmeldetag: 20.06.2014
(51) Int. Cl.: G05B 9/03, G05B 19/05, H01H 71/10, H03K 19/007

(54) **SICHERHEITSSCHALTVORRICHTUNG ZUR DETEKTION VON FEHLERHAFTEN EINGÄNGEN**
SAFETY SWITCHING DEVICE FOR DETECTING FAULTY INPUTS
DISPOSITIF DE COMMUTATION DE SÉCURITÉ POUR DÉTECTER DES ENTRÉES NON CONFORMES

(30) Priorität: 27.06.2013 DE 102013106739
(43) Veröffentlichungstag der Anmeldung: 04.05.2016
(73) Patentinhaber: Pilz GmbH & Co. KG, 73760 Ostfildern (DE)
(72) Erfinder: VEIL, Richard, 73760 Ostfildern (DE); SEIZINGER, Dietmar, 73760 Ostfildern (DE); KLUGE, Marco, 73760 Ostfildern (DE)
(74) Vertreter: Witte, Weller & Partner Patentanwälte mbB
(86) Internationale Anmeldenummer: PCT/EP2014/063036
(87) Internationale Veröffentlichungsnummer: WO 2014/206885

(56) Entgegenhaltungen:
- EP-A1- 1 785 791
- EP-A2- 1 873 915
- EP-A2- 2 506 436
- DE-B3-102010 054 386

## Beschreibung

Die vorliegende Erfindung betrifft eine Sicherheitsschaltvorrichtung zum fehlersicheren Abschalten einer technischen Anlage, mit einem ersten und mindestens einem zweiten Eingang zum Aufnehmen eines Eingangssignals eines Meldegeräts.

Die Erfindung betrifft ferner ein Verfahren zum Testen von Eingängen einer Sicherheitsschaltvorrichtung.

Ganz allgemein betrifft die Erfindung das Gebiet der Sicherheitstechnik im Sinne vom Schutz von Personen und/oder materiellen Werten vor Gefahren, die von automatisiert arbeitenden Anlagen oder Maschinen ausgehen, wie bspw. vollautomatisiert arbeitenden Robotern. Zur Absicherung derartiger Anlagen werden verschiedene Meldegeräte, wie bspw. Not-Aus-Schalter, Positionsschalter oder berührungslos arbeitende Signalgeber wie Lichtschranken und Lichtgitter, verwendet, mit denen der Zugang zu einer Anlage und deren sichere Funktion überwacht werden kann. Die Meldegeräte sind mit einer Sicherheitsschaltvorrichtung gekoppelt, die in Abhängigkeit der Meldegeräte die technische Anlage in einem sicherheitsunkritischen Zustand überführen kann, insbesondere abschaltet. Es ist daher von großer Bedeutung, dass der von einem Meldegerät übermittelte Zustand von der Sicherheitsschaltvorrichtung richtig erkannt wird, insbesondere der AUS-Zustand, also der Zustand an dem die Anlage abzuschalten ist.

Um auch bei einem defekten Eingang ein fehlersicheres Abschalten der technischen Anlage zu ermöglichen, werden die Meldegeräte häufig zweikanalig, also redundant über zwei Eingänge, an die Sicherheitsschaltvorrichtung angeschlossen. Durch die Redundanz wird gewährleistet, dass auch bei einem Fehler in einem Kanal die Anlage abgeschaltet wird. Bei diesem Vorgehen wird ein kritischer Fehler somit ausgeschlossen, jedoch nicht unmittelbar erkannt, d.h., die Sicherheitsfunktion wird gewahrt, jedoch der Fehler in einem Kanal nicht aufgedeckt. Um den Fehler nicht nur auszuschließen, sondern auch zu erkennen, werden die Eingänge von Sicherheitsschaltvorrichtungen mit Selbsttestfunktionen ausgestattet, mit denen das Detektionsvermögen eines einzelnen Eingangs überprüft werden kann. Derartige Eingangsschaltungen sind bspw. aus der DE 10 2006 030 114 B4 oder der DE 10 2011 015 498 A1 bekannt.

Die DE 10 2006 030 114 B4 offenbart eine Eingangsschaltung zum Einlesen von Eingangssignalen eines Meldegeräts mit einem Signaleingangsschaltkreis und mit einem über ein Koppelglied anschaltbaren Auswertekreis. Das Koppelglied ist mit einer Referenzspannungsquelle verbunden, über die eine Schaltschwelle eingestellt werden kann, die vom Eingangssignal mindestens überschritten werden muss. Weiterhin weist die Eingangsschaltung eine erste Testschaltung zum Überprüfen der Referenzspannungsquelle auf und eine zweite Testschaltung, mit der im Signaleingangsschaltkreis eine Spannung eingespeist werden kann, um das Koppelglied zu überprüfen. Nachteilig bei der gezeigten Eingangsschaltung ist jedoch, dass die Testschaltungen je ein oder zwei galvanisch getrennte Koppelelemente aufweisen, um eine galvanische Trennung zwischen dem Signaleingangsschaltkreis und einer nachgeschalteten Logikeinheit, die die Tests steuert, zu ermöglichen. Derartige Koppelelemente sind gegenüber den anderen Bauteilen der Eingänge teuer, benötigen viel Platz und haben eine hohe Ausfallrate.

Die DE 10 2011 015 498 A1 zeigt eine weitere Eingangsschaltung mit einem Signaleingangsschaltkreis und mit einem über ein Koppelglied anschaltbaren Auswertekreis. Dem Koppelglied ist eine zusätzliche Transistorschaltung vorgeschaltet, so dass ein sicherer Zustand sowohl über den Strom des Eingangssignals als auch über die Spannung detektiert werden kann. Die Schaltschwelle wird über eine Spannungsreferenz eingestellt. Wie bei der DE 10 2006 030 114 B4 sind zwei Testschaltungen vorgesehen. Eine erste Testschaltung überprüft das Koppelglied und den vorgeschalteten Transistor und die zweite Testschaltung dient der Überprüfung der Referenzspannung. Die erste und die zweite Testschaltung weisen Koppelelemente zur galvanischen Trennung des Signaleingangsschaltkreises von einer nachgeschalteten Logikeinheit auf. Insgesamt werden mindestens drei Koppelelemente für die Testeinrichtungen benötigt. Vorteilhaft bei der gezeigten Eingangsschaltung ist, dass nur eine Referenzspannungsquelle benötigt wird und somit auch nur eine Testschaltung für diese bereitgestellte werden muss. Nachteilig ist jedoch, dass durch die zweite Testschaltung nicht vollständig alle Parameter, die zum Einstellen der Schaltschwelle verwendet werden, überprüft werden, da die Schaltschwelle in der gezeigten Schaltung nicht nur von der Spannungsreferenz, sondern auch von den Parametern der anderen Bauteile, insbesondere der Parameter der vorgeschalteten Transistorschaltung, abhängig ist.

EP 1 785 791 A1 offenbart eine Eingangsschaltung zum Aufnehmen redundanter Eingangssignale eines Sicherheitsgebers. Die Eingangsschaltung ist dazu eingerichtet, Selbsttests durchzuführen. Hierzu weisen die Eingänge vier Optokoppler auf.

Vor diesem Hintergrund ist es eine Aufgabe der vorliegenden Erfindung eine alternative Eingangsschaltung für eine eingangs genannte Sicherheitsschaltvorrichtung anzugeben, die bessere Testmöglichkeiten bietet, kostengünstiger ist und einen geringeren Platzbedarf aufweist.

Gemäß einem Aspekt der Erfindung wird die Aufgabe durch eine Sicherheitsschaltvorrichtung zum fehlersicheren Abschalten einer technischen Anlage, mit einem ersten und mindestens einem zweiten Eingang gelöst, wobei der erste Eingang ein erstes Eingangssignal mit einer ersten Eingangsschaltung aufnimmt und der zweite Eingang ein zweites Eingangssignal mit einer zweiten Eingangsschaltung aufnimmt, wobei die erste und die zweite Eingangsschaltung in einen ersten und einen zweiten Schaltkreis unterteilt sind, die galvanisch voneinander getrennt sind, wobei im ersten Schaltkreis eine erste Signaleingangsschaltung, ein erstes Schwellwertelement und eine erstens Koppelement der ersten Eingangsschaltung sowie eine zweite Signaleingangsschaltung, ein zweites Schwellwertelement und ein zweites Koppelelement der zweiten Eingangsschaltung angeordnet sind, wobei der erste Schaltkreis ferner eine erste Testeinrichtung mit einem dritten Koppelelement aufweist, wobei die erste Testeinrichtung dazu ausgebildet ist, einen Strompfad vom ersten und zweiten Schwellwertelement zu einem Masseanschluss zu unterbrechen, wobei der zweite Schaltkreis eine zweite Testeinrichtung und einen ersten Ausleiteschaltkreis des ersten Eingangs und eine dritte Testeinrichtung und einen zweiten Ausleiteschaltkreis des zweiten Eingangs aufweist, wobei der erste und zweite Ausleiteschaltkreis das jeweilige Eingangssignal für eine nachfolgende, zweikanalig redundante Signalverarbeitung auf zwei Kanäle aufteilen,, wobei das erste, zweite und dritte Koppelelement den ersten und den zweiten Schaltkreis miteinander verbinden, und wobei die zweite und die dritte Testeinrichtung ohne ein Koppelelement auskommen.

Gemäß einem anderen Aspekt der Erfindung wird die Aufgabe durch ein entsprechendes Verfahren zum fehlersicheren Einlesen von binären Zuständen an einem ersten und mindestens einem zweiten Eingang einer Sicherheitsschaltvorrichtung gelöst.

Der Erfindung liegt somit die Idee zugrunde, eine Eingangsschaltung in zwei, voneinander galvanisch getrennte Bereiche zu unterteilen, die nur an definierten, möglichst wenigen Stellen durch Koppelelemente verbunden sind. Jeder Bereich weist eine separate Testeinrichtung auf, mit denen in einem zweistufigen Testverfahren zum einen das Detektionsvermögen des Eingangs überprüft werden kann und zum anderen eine Fehlerhäufung in nachgeschalteten, redundanten Schaltungsteilen aufgedeckt werden kann.

Der erste Schaltkreis weist für jeden Eingang eine separate Signaleingangsschaltung und ein separates Schwellwertelement auf. Über die Signaleingangsschaltung wird ein Eingangssignal aufgenommen und mittels des ersten Koppelelements an den zweiten Schaltkreis übertragen, sofern das Eingangssignal den vom Schwellwertelement gesetzten Schwellwert überschreitet. Mit anderen Worten findet im ersten Schaltkreis die Detektion des Eingangszustands statt, wobei ein erster Zustand erkannt wird, wenn das Eingangssignal den Schwellwert überschreitet und ein zweiter Zustand erkannt wird, wenn der Schwellwert vom Eingangssignal unterschritten wird.

Der erste Schaltkreis weist ferner eine erste Testeinrichtung auf, über die die Schwellwertelemente der Eingangsschaltungen aktiviert und deaktiviert werden können, um bewusst einen Zustandsübergang herbeizuführen. Durch Auswerten des Zustandsübergangs kann auf die Funktionsfähigkeit der Schwellwertdetektion geschlossen werden. Da der erste Schaltkreis ferner vorteilhaft aus diskreten, einzelnen Bauteilen aufgebaut ist und somit Kurzschlüsse zwischen den Bauteilen ausgeschlossen werden können, können so durch die erste Testeinrichtung alle anzunehmenden, gefahrbringenden Einzelfehler im ersten Schaltkreis erkannt werden. Insbesondere wird gewährleistet, dass der AUS-Zustand fehlerfrei erkannt wird, also der Zustand eines Eingangssignals, der angibt, dass die Anlage in einem unsicheren bzw. unbestimmten Zustand ist.

Besonders vorteilhaft kann die erste Testeinrichtung zugleich das Detektionsvermögen mehreren Eingängen testen, so dass insgesamt nur ein drittes Koppelement für alle Eingänge benötigt wird. Dies reduziert zum einen den benötigten Bauraum zum andern anderen wird die Anzahl der benötigten Koppelelemente vorteilhaft reduziert.

Der zweite Schaltkreis bildet den Übergang zu einem dem Eingang nachgeschalteten Schaltungsteil, in dem die weitere Signalverarbeitung stattfindet. Der nachgeschalteten Schaltungsteil, vorzugsweise ein Logikeinheit mit einem Mikrokontroller, ist aus integrierten Bauteilen aufgebaut, so dass Kurzschlüsse zwischen den Signalen dort nicht ausgeschlossen werden können. Um Fehler durch Kurzschlüsse in diesem Schaltungsteil auszuschließen, ist die Signalverarbeitung in diesen Teilen mehrkanalig redundant. Durch die Mehrkanaligkeit kann zwar ein Fehler beherrscht werden, jedoch kann für einen einzelnen Kanal nicht eindeutig bestimmt werden, ob er fehlerfrei arbeitet, d.h., die Sicherheit bei einem einzelnen Fehler wird gewährleistet, jedoch keine Fehlererkennung. Dies wird vorteilhafterweise durch die zweite Testeinrichtung erreicht. Die zweite Testeinrichtung ist dazu im zweiten Schaltkreis angeordnet und ist ausgebildet, den Signalfluss in Abhängigkeit eines Testsignals zu unterbrechen. Da das Detektionsvermögen bereits durch die erste Schalteinrichtung gewährleistet ist, kann durch das bewusste Auftrennen des Signalflusses durch die zweite Testeinrichtung ein Fehler, beispielsweise ein Kurzschluss zwischen zwei Eingängen des IC, im mehrkanaligen Schaltungsteil aufgedeckt werden.

Vorteilhafterweise ist die zweite Testeinrichtung im zweiten Schaltkreis angeordnet und somit vollständig galvanisch getrennt von einem anliegenden Eingangssignal. Durch die galvanische Trennung ist der zweite Schaltkreis vorteilhaft vor transienten Überspannungen und Gleichtaktstörimpulsen geschützt, die an den Eingängen auftreten können. Die zweite Testeinrichtung kann folglich im Gegensatz zur ersten Testeinrichtung unmittelbar an eine Logikeinheit zum Aufnehmen eines Testsignals angeschlossen werden und benötigt kein zusätzliches Koppelelement. Koppelelemente, insbesondere Optokoppler, sind teuer und benötigen im Vergleich zu anderen Bauteilen viel Platz, so dass sich eine Reduzierung dieser Bauteile vorteilhaft auf die physikalische Größe der Eingangsschaltung die Herstellungskosten auswirkt.

Insgesamt kann durch die neue Vorrichtung und das zweistufige Testen vorteilhaft die Anzahl der benötigten Bauteile reduziert werden und gleichzeitig die Fehlererkennung, insbesondere im Hinblick auf Fehlerhäufungen in den nachgeschalteten Schaltungsteilen, verbessert werden.

Die oben genannte Aufgabe ist damit vollständig gelöst.

In einer bevorzugten Ausgestaltung weist die zweite Testeinrichtung ein erstes Schaltelement und die dritte Testeinrichtung ein zweites Schaltelement auf, wobei das erste Schaltelement in einen Strompfad zwischen dem ersten Koppelelement und dem ersten Ausleiteschaltkreis angeordnet ist und das zweite Schaltelement in einem Strompfad zwischen dem zweiten Koppelelement und dem zweiten Ausleiteschaltkreis angeordnet ist.

In dieser Ausgestaltung kann die zweite und dritte Testeinrichtung in Abhängigkeit eines einzelnen Testsignals oder separaten Testsignalen den Strompfad zwischen der Sekundärseite der Koppelelemente zur Schwellwertdetektion und den Ausleiteschaltkreisen trennen. Auf diese Weise lässt sich besonders einfach die nachfolgende zweikanalige Signalverarbeitungseinheit auf Einzelfehler in einem Kanal testen.

In einer weiteren Ausgestaltung weist die erste und zweite Signaleingangsschaltung EMV-Bauteile auf, mit mindestens einer Spannungsbegrenzungseinrichtung, insbesondere einer Zener-Diode.

Durch die Spannungsbegrenzungseinrichtung kann eine Spannung in der Eingangsschaltung auf einen Maximalwert begrenzt werden. Vorteilhafterweise können die Bauelemente nach der Spannungsbegrenzungseinrichtung für geringere Spannung ausgelegt sein.

In einer weiteren Ausgestaltung weist die erste und/oder zweite Signaleingangsschaltung eine Strombegrenzungseinrichtung auf, die einen Stromfluss in die erste und/oder zweite Eingangsschaltung begrenzt.

Die Strombegrenzungseinrichtung, vorzugsweise ein Längsregler, definiert einen maximalen Strom, der in die Eingänge fließen kann. Durch die Begrenzung der Eingangsströme, kann eine Verlustleistung an den Eingängen reduziert werden. Insbesondere, wenn viele Eingänge geschaltet sind, kann die Summe der Verlustleistung zu einem erheblichen, unnötigen Stromverbrauch führen, der durch diese Ausgestaltung vorteilhaft begrenzt wird.

Erfindungsgemäß teilt der erste und zweite Ausleiteschaltkreis für eine nachfolgende, zweikanalig redundante Signalverarbeitung das jeweilige Eingangssignal auf zwei Kanäle auf.

Da die Signalverarbeitung in Schaltungsteilen nach dem Ausleiteschaltkreis vorzugweise durch integrierte Schaltungen vorgenommen wird, ist mit Querschlüssen in diesen Schaltungsteilen zu rechnen. Durch eine zweikanalige Signalverarbeitung können Fehler in diesen Schaltungsteilen beherrscht werden.

In einer besonders bevorzugten Ausgestaltung weisen die Ausleiteschaltkreise zum Unterdrücken von Rückwirkungen für jeden Kanal Trennelemente auf.

Durch diese Ausgestaltung kann ein Fehler innerhalb eines Kanals der zweikanaligen Signalverarbeitung nicht auf den jeweils anderen Kanal zurückwirken. Vorzugsweise werden dazu Trennwiderstände, die zusätzlich noch gewendelt sein können, längs in jedem Kanal angeordnet.

In einer weiteren besonders bevorzugten Ausgestaltung findet die nachfolgende Signalverarbeitung in getrennten Kanälen statt, die unterschiedlich ausgebildet sind.

Gemäß dieser Ausgestaltung wird die Fehlersicherheit in diesen Schaltungsteilen zusätzlich zur Redundanz noch durch die Diversität der einzelnen Kanäle vorteilhaft erhöht.

In einer weiteren Ausgestaltung folgt dem ersten und dem zweiten Ausleiteschaltkreis ein nachgeschalteter redundanter Schaltungsteil, wobei die erste Testeinrichtung dazu ausgebildet ist, ein Detektionsvermögen der Eingänge zu überprüfen und die zweite und dritte Testeinrichtung dazu ausgebildet sind, einen Fehler in einem redundanten Schaltungsteil zu erkennen und damit Fehlerhäufung zu beherrschen.

Gemäß dieser Ausgestaltung testen die erste Testeinrichtung unabhängig von der zweiten und dritten Testeinrichtung die Eingänge gemäß verschiedener Sicherheitsprinzipien. Die erste Testeinrichtung prüft das Detektionsvermögen der Eingänge auf Einzelfehler in der Eingangsschaltung und die zweite und dritte Testeinrichtung deckt Fehler in nachfolgenden Schaltungsteilen auf, die für sich durch die Redundanz ungefährlich sind, aber durch Fehlerhäufung gefährlich werden könnten.

In einer weiteren Ausgestaltung sind das erste und das zweite Schwellwertelement redundant ausgelegt, insbesondere mit zwei Zener-Dioden.

Durch die redundante Auslegung der Schwellwertelemente kann ein Driften eins Elements vorteilhaft kompensiert werden.

In einer weiteren Ausgestaltung ist zur Filterung von langsamen Störsignalen nach dem ersten und zweiten Ausleiteschaltkreis eine Logikeinheit mit Filterelementen angeordnet.

Eine nach den Eingängen angeordnete Logikeinheit führt eine weitere Signalverarbeitung des Eingangssignals aus, insbesondere werden langsame Störsignale durch Filter entfernt, die vorzugsweise in Form von Software in der Logikeinheit implementiert sind. Filter in der Logikeinheit können einfach auf verschiedene Störsignale angepasst werden.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine vereinfachte Darstellung einer automatisiert arbeitenden Anlage, in der ein Ausführungsbeispiel der neuen Sicherheitsschaltvorrichtung verwendet wird,
- Fig. 2: eine vereinfachte schematische Darstellung einer neuen Eingangsschaltung einer Sicherheitsschaltvorrichtung,
- Fig. 3: ein Ausführungsbeispiel einer Implementierung einer neuen Eingangsschaltung,
- Fig. 4: ein weiteres Ausführungsbeispiel einer Implementierung einer Eingangsschaltung mit zwei Eingängen, und
- Fig. 5: eine schematische Darstellung eines Eingangsmoduls der neuen Sicherheitsschaltvorrichtung.

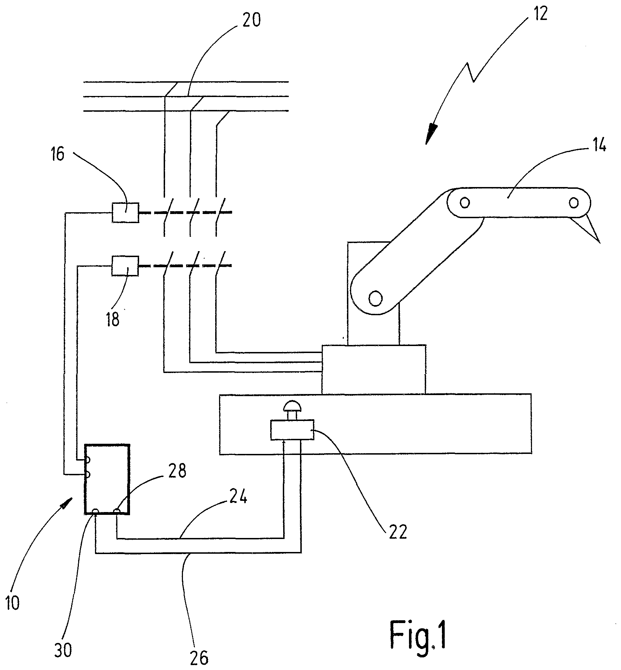

In Fig. 1 ist ein Ausführungsbeispiel der neuen Sicherheitsschaltvorrichtung mit der Bezugsziffer 10 bezeichnet. Die Sicherheitsschaltvorrichtung 10 wird hier beispielhaft zum Absichern einer automatisiert arbeitenden Anlage 12 verwendet, die durch einen Roboter 14 angedeutet ist. Die Antriebe des Roboters 14 sind in an sich bekannter Weise über zwei Leistungsschütze 16, 18 an eine Stromversorgung 20 angeschlossen. Die Arbeitskontakte der zwei Leistungsschütze 16, 18 liegen in Reihe zueinander im Strompfad der Stromversorgung und ermöglichen redundante Abschaltwege. Angesteuert werden die Leistungsschütze 16, 18 von der Sicherheitsschaltvorrichtung 10, die die Schütze nur einschaltet, wenn durch die angeschlossenen Meldegeräte ein sicherer Zustand angezeigt wird.

Als Meldegerät 22 ist hier an der Anlage 12 beispielhaft ein Not-Aus-Schalter 22 mit Zwangsöffnung angedeutet, dessen Öffnerkontakte über eine erste Leitung 24 mit einem Ausgang 28 und über eine zweite Leitung 26 mit einem Eingang 30 der Sicherheitsschaltvorrichtung 10 verbunden sind. Der Ausgang 28 ist hier von der Sicherheitsschaltvorrichtung 10 mit einem statischen Potential belegt, welches im unbetätigten Zustand des Not-Aus-Schalters 22 aufgrund der Zwangsöffnung auch am Eingang 30 anliegt. Wird der Not-Aus-Schalter 22 betätigt, wird der Öffnerkontakt physikalisch geöffnet, so dass die Verbindung zwischen dem Ausgang 28 und dem Eingang 30 getrennt wird. Das Ausbleiben des statischen Potential am Eingang 30 wird von der Sicherheitsschaltvorrichtung 10 erkannt, worauf die Leistungsschütze 16, 18 ausgeschaltet werden und die Stromversorgung zu den Antrieben des Roboter 14 unterbrochen wird. Durch das Stromlosschalten geht der Roboter 14 in einen sicheren Zustand über.

Anstelle des Not-Aus-Schalters 22 können auch anderer Meldegeräte verwendet werden, bspw. Positionsschalter, Schutztürschalter oder berührungslos arbeitende Meldegeräte, wie Lichtschranken oder Lichtgitter. Ebenso muss die Sicherheitsfunktion nicht zwangsläufig darin bestehen, einen Prozess stromlos zuschalten. Unter bestimmten Umständen kann es ausreichend sein, ein Maschine gesteuert still zusetzen. Voraussetzung bei allen Varianten ist jedoch, dass das Ausbleiben eines den sicheren Zustand anzeigenden Signals, also die Detektion des AUS-Zustands, fehlersicher und zuverlässig von der Sicherheitsschaltvorrichtung 10 erkannt wird. Den Eingängen der Sicherheitsschaltvorrichtung 10 kommt daher eine große Bedeutung zu.

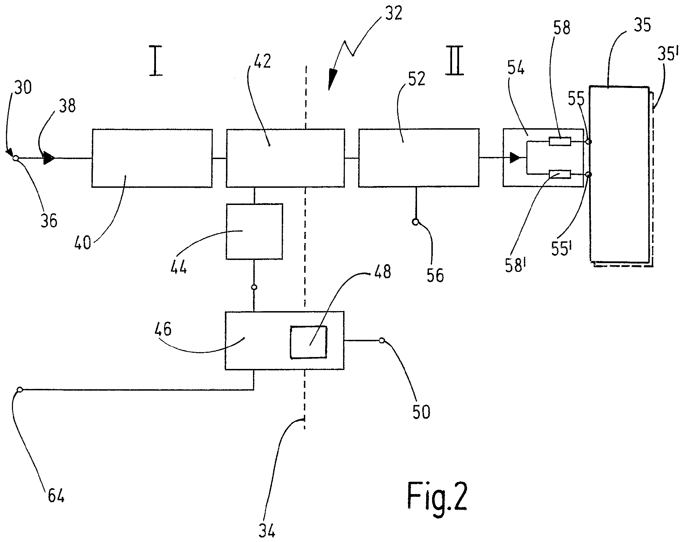

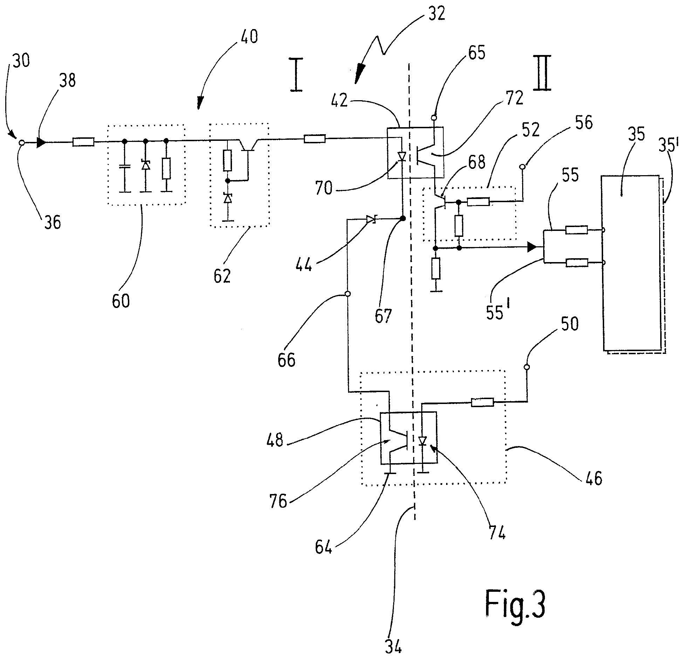

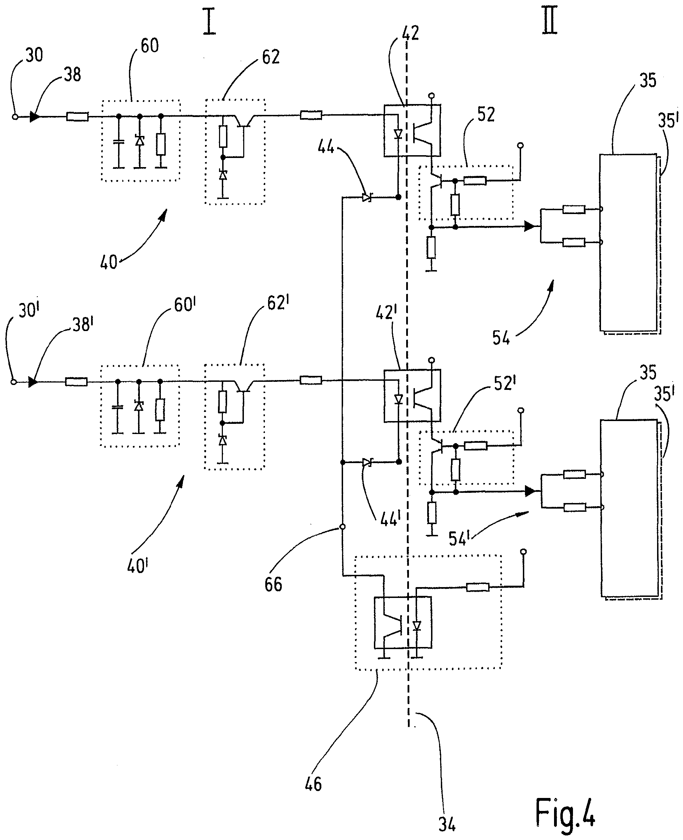

Bezug nehmend auf die Fig. 2 und 3 wird im Folgenden zunächst die Funktionsweise eines einzelnen neuen Eingangs 30 und der dazugehörigen Eingangsschaltung 32 näher erläutert. Fig. 4 zeigt anschließend das Ausführungsbeispiel gemäß der Fig. 2 und 3 erweitert um einen zusätzlichen zweiten Eingang 30'

Fig. 2 zeigt eine schematische Darstellung eines Ausführungsbeispiels einer neuen Eingangsschaltung 32. Die funktionalen Einheiten der Eingangsschaltung sind durch Funktionsblöcke dargestellt.

Die Eingangsschaltung 32 teilt sich in einen ersten (I) und einen zweiten Schaltkreis (II) auf, die über Koppelemente vollständig galvanisch voneinander getrennt sind. Die galvanische Trennung 34 dient dem Schutz der nachfolgenden Bauteile vor Zerstörung durch Überspannungen und daraus resultierenden Fehlern beim Erkennen des AUS-Zustandes. Die galvanische Trennung 34 ist hier durch eine gestrichelte Linie angedeutet.

Der erste Schaltkreis (I) des Eingangs 30 bildet die Primärseite der Eingangsschaltung 32. Auf der Primärseite befindet sich ein Peripherieanschluss 36, über den ein Eingangssignal 38 von einem Meldegerät aufgenommen wird. Bei dem Eingangssignal 38 handelt es sich vorzugsweise um ein binäres Signal mit zwei definierten Zuständen, wie sie beispielsweise durch zwei statische Potentiale gegeben seien können. Die Zustände sind allgemein durch verschiedene Spannungspegel gekennzeichnet, wobei ein erster Zustand angenommen wird, wenn die Spannung einen definierten Schwellwert unterschreitet und ein zweiter Zustand vorliegt, wenn ein definierter Schwellwert überschritten ist. Die Schwellwerterkennung erfolgt hier, wie noch näher zu erläutern ist, mit Hilfe des Koppelelements 42 und einem Schwellwertelement 44.

Das Eingangssignal 38 wird zunächst einer Signaleingangsschaltung 40 zugeführt, die elektrische oder elektromagnetische Störeffekte unterdrückt. Die Signaleingangsschaltung 40 kann bspw. ein oder mehrere Filterelemente zur Gewährleistung der elektromagnetischen Verträglichkeit, Spannungsbegrenzungselemente und/oder eine Strombegrenzung aufweisen. Anschließend wird das von Störeffekten "gereinigte" Eingangssignal 38 dem ersten Koppelelement 42 zugeführt. Das Koppelelement 42 übernimmt zwei Funktionen. Zum einen wird über das Koppelelement 42 das Eingangssignal 38 zum zweiten Schaltkreis (II) übertragen und zum anderen wird mit Hilfe des nachgeordneten Schwellwertelements 44 eine Schwellwertdetektion durchgeführt, indem nur ein Signal, dessen Spannungspegel einen definierten Schwellwert überschreitet, an den zweiten Schaltkreis (II) übertragen wird. Mittels der Schwellwertdetektion erfolgt an dieser Stelle somit die Zuordnung des Eingangssignals 38 zu entweder dem ersten oder dem zweiten logischen Zustand.

Für die Schwellwertdetektion verfügt der erste Schaltkreis (I) neben dem ersten Koppelelement 42 über ein Schwellwertelement 44, welches im einfachsten Fall eine Spannungsreferenz zum Beispiel in Form einer Zener-Diode ist. Das Schwellwertelement 44 ist ferner mit einer ersten Testeinrichtung 46 verbunden, anhand welcher die Schwellwertdetektion getestet werden kann. Die erste Testeinrichtung 46 ist im ersten Schaltkreis (I) vorzugsweise zwischen dem Schwellwertelement 44 und einem Masseanschluss 64 angeordnet und über ein zusätzliches drittes Koppelelement 48 mit dem zweiten Schaltkreis (II) verbunden. Über das dritte Koppelelement 48 kann die erste Testeinrichtung 46 von einem Steuersignal auf der Seite des zweiten Schaltkreises (II) betätigt werden. Vorzugsweise ist die erste Testeinrichtung 46 dazu über einen Gruppentestanschluss 50 mit einer nachfolgenden Logikeinheit 35 verbunden.

Die erste Testeinrichtung 46 ist dazu ausgebildet, in Abhängigkeit von einem Steuersignal der Logikeinheit 35 das Schwellwertelement 44 zu deaktivieren, wodurch sich der Schwellwert ändert, so dass auch bei Vorhandensein eines den sicheren Zustand repräsentierenden Eingangssignals ein AUS-Zustand angezeigt wird. Wird dieser bewusste Zustandsübergang registriert, kann auf die ordnungsgemäße Funktion des Koppel- und des Schwellwertelements 42, 44 geschlossen werden. Da durch den bevorzugten diskreten Aufbau des Schaltkreises (I) mit Hilfe von diskreten Bauelementen, die auf einer gedruckten Leiterplatte fest verdrahtet sind, Kurzschlüsse zwischen den Eingängen ausgeschlossen werden können, lassen sich durch die erste Testeinrichtung 46 somit alle anzunehmenden, gefahrbringenden Einzelfehler erkennen und, bspw. durch Steuern der Anlage 12 in einen sicheren Zustand, beherrschen. Vorzugsweise wird der Test in relativ kurzen Intervallen von weniger als 500ms, beispielsweise in Zeitabständen von 200ms, durchgeführt. In einer besonders bevorzugten Ausgestaltung können durch die erste Testeinrichtung 46 mehrere Koppel- und Schwellwertelemente gleichzeitig getestet werden.

Der zweite Schaltkreis (II) weist ferner eine separate zweite Testeinrichtung 52 und einen Ausleiteschaltkreis 54 auf. Die zweite Testeinrichtung 52 ist hier zwischen der Sekundärseite des ersten Koppelelements 42 und dem Ausleiteschaltkreis 54 angeordnet. Über einen Einzeltestanschluss 56 ist auch die zweite Testeinrichtung 52 mit der Logikeinheit 35 verbindbar. Das Eingangssignal 38 wird vom ersten Koppelelement 42, sofern es den eingestellten Schwellwert überschreitet, zum Ausleiteschaltkreis 54 übertragen. Vom Ausleiteschaltkreis 54 gelangt das Eingangssignal 38 zu der nachgelagerten Logikeinheit 35 zur weiteren Signalverarbeitung.

Die Logikeinheit 35 ist vorzugsweise mit integrierten Halbleiterbauelementen, insbesondere Mikrokontrollern, ASICs, FPGAs oder anderen integrierten Logikbauelementen aufgebaut und zweikanalig ausgelegt, um eine sichere Signalverarbeitung zu gewährleisten. Vorzugsweise sind die zwei Kanäle weiterhin unterschiedlich aufgebaut, damit zu der Redundanz durch die mehrkanalige Auslegung auch eine zusätzliche Diversität gegeben ist. Die Diversität und Redundanz kann unter anderem beispielsweise durch zwei funktionsgleiche, von unterschiedlichen Herstellern produzierte Mikrokontroller gewährleistet sein, wie hier durch den zusätzlichen Mikrokontroller 35' angedeutet ist. Der Ausleiteschaltkreis 54 teilt unabhängig von der nachfolgenden Realisierung das Eingangssignal auf zwei Kanäle 55, 55' auf und stellt über zwei Trennelemente 58, 58' pro Kanal sicher, dass ein Kanal nicht auf den anderen zurückwirken kann. Die Trennelemente 58, 58' können vorteilhaft als Längswiderstände ausgebildet sein.

Die Redundanz und die Diversität der Schaltungsteile, die dem Ausleiteschaltkreis 54 nachfolgen, reichen aus, um dort auftretende Einzelfehler, d.h. Fehler innerhalb oder am Eingang von Bauteilen eines Kanals, zu beherrschen, da der jeweilige Nachbarkanal das Signal noch richtig erkennt. Mit Beherrschen ist in diesem Zusammenhang gemeint, dass bei einem Fehler in einem Kanal der sicherheitskritische Prozess durch das Vorliegen des Signals auf dem anderen Kanal sicher gesteuert werden kann und die Sicherheitsschaltvorrichtung 10 somit ihrer primäre Aufgabe nachkommt. Die Sicherheitsfunktion geht somit trotz des Einzelfehlers nicht verloren. Die zweikanalige Auslegung ermöglicht für sich genommen jedoch nicht, das Vorliegen eines Fehlers zu lokalisieren. Zudem kann die Anhäufung mehrerer Einzelfehler in ihrer Summe zum Verlust der Sicherheitsfunktion führen (Prinzip der Fehlerhäufung). Die zweite Testeinrichtung 52 ist daher dazu ausgelegt, Einzelfehler im zweikanaligen Schaltungsteil aufzudecken.

Die zweite Testeinrichtung 52 weist vorzugsweise ein Schaltelement im Strompfad zwischen der Sekundärseite des ersten Koppelelements 42 und dem Ausleiteschaltkreis 54 auf. In Abhängigkeit eines Testsignals am Einzeltestanschluss 56 kann die zweite Testeinrichtung 52 somit den Signalfluss zwischen dem zweiten Koppelelement 42 und dem Ausleiteschaltkreis 54 trennen. Durch das bewusste Trennen des Signalflusses nach dem ersten Koppelelement 42 und somit auch nach der Schellwertdetektion können durch die zweite Testeinrichtung 52 Fehler im redundanten Signalverlauf aufgedeckt werden, da Fehler bei der Detektion bereits durch die erste Testeinrichtung 46 ausgeschlossen werden können.

Da sich die zweite Testeinrichtung 52 im zweiten Schaltkreis II befindet, wird kein weiteres Koppelelement benötigt, da die zweite Testeinrichtung 52 bereits vollständig von dem am Eingang 30 anliegenden Eingangssignal 38 galvanisch getrennt ist. Die zweite Testeinrichtung 52 lässt sich somit besonders einfach und kostengünstig, vorzugsweise durch ein einfaches Schaltelement realisieren. Ferner können die Testintervalle für die Einzeltests im Vergleich zu den Testintervallen des ersten Testelements 46 sehr viel länger ausgelegt sein, bspw. in Sekundentakt, da die zweite Testeinrichtung 52 im Wesentlichen zum Aufdecken von Fehlerhäufungen verwendet wird und somit keine Fehler aufdeckt, die unmittelbar zum Verlust der Sicherheitsfunktion führen.

Insgesamt beschreibt die Fig. 2 eine günstige Eingangsschaltung 32, die über eine hohe Fehlersicherheit hinsichtlich des Detektionsvermögens der AUS-Zustände verfügt. Insbesondere kann die Anzahl der verwendeten Koppelelemente auf ein Minimum reduziert werden, da die Überprüfung der Sicherheitsfunktion zweistufig durchgeführt wird und die zweite Testeinrichtung 52 ohne ein Koppelelement auskommt.

Bezug nehmend auf die Fig. 3 wird im Folgenden eine vorteilhafte Implementierung der in der Fig. 2 gezeigten Schaltungen näher erläutert. Gleiche Bezugszeichen bezeichnen gleiche Teile.

Der erste Schaltkreis (I) und der zweite Schaltkreis (II) sind galvanisch voneinander getrennt, wie hier durch die gestrichelte Linie 34 angedeutet ist. Die galvanische Trennung 34 verläuft durch das erste Koppelelement 42 und das dritte Koppelelement 48. Eine weitere Verbindung zwischen den beiden Schaltkreisen (I, II) besteht nicht.

Ein Eingangssignal 38 wird über den Peripherieanschluss 36 eingespeist und zunächst in einer Signaleingangsschaltung 40 verarbeitet. Die Signaleingangsschaltung 40 umfasst eine erste Gruppe von EMV-Bauteilen 60 und eine zweite Gruppe mit Bauteilen zur Strombegrenzung 62. Die EMV-Bauteile 60 umfassen hier Kondensatoren, Widerstände und Dioden zur Glättung des Eingangssignals 38 bzw. zur Begrenzung einer definierten Eingangsspannung. Die Strombegrenzungseinrichtung 62 umfasst hier einen Längsregler, der einen maximalen Stromfluss in den Eingang 30 festlegt.

Der Signaleingangsschaltung 40 folgt das erste Koppelelement 42, welches hier ein Optokoppler mit einem Leuchtdiodenkreis 70 auf der Primärseite und einem Kollektor-Emitter-Kreis 72 auf der Sekundärseite ist. Die Primär- und Sekundärseite 70, 72 sind voneinander galvanisch getrennt. Über das erst Koppelelement 42 wird das Eingangssignal 38 zum zweiten Schaltkreis (II) übertragen, wobei über das Schwellwertelement 44 ein definierter Schwellwert eingestellt wird, den das Eingangssignal 38 überschreiten muss, um zum zweiten Schaltkreis (II) übertragen zu werden. Das Koppelelement 42 und das Schwellwertelement 44 "detektieren" somit den jeweiligen Zustand des Eingangssignals 38 und sind folglich maßgeblich für die Detektion des AUS-Zustands zuständig.

Bei dem Schwellwertelement 44 handelt es sich hier um eine einfache Spannungsreferenz in Form einer Zener-Diode, die unmittelbar am Ausgang des Leuchtdiodenkreises 70 des Optokopplers angeordnet ist, sodass sich am Punkt 67 ein definierter Spannungspegel (zuzüglich der Diodenspannung der Leuchtdiode 70) als Schwellwert einstellt. Erst wenn ein Eingangssignal 38 diesen Spannungspegel überschreitet, fließt ein Strom durch die Leuchtdiode 70 des Optokopplers, so dass die Kollektor-Emitter-Strecke 72 des Optokopplers leitend wird.

Das Schwellwertelement 44 ist ferner über die erste Testeinrichtung 46 mit einem Masseanschluss 64 verbunden. Vorzugsweise ist der Masseanschluss 64 galvanisch mit einer Anschlussklemme (hier nicht dargestellt) am Gehäuse der Sicherheitsschaltvorrichtung 10 verbunden, so dass das Massepotential auch "außen" zur Verfügung gestellt ist. In bevorzugten Implementierungen ist das Massepotential am Anschluss 64 ein Massepotential, an das auch das Meldegerät angeschlossen ist, das das Eingangssignal am Eingang 30 liefert. Die erste Testeinrichtung 46 weist einen weiteren Optokoppler 48 auf, dessen Primärseite 74 im zweiten Schaltkreis (II) liegt und mit einem Gruppentestanschluss 50 zum Einspeisen eines Steuersignals verbunden ist. Auf der Sekundärseite 76 ist die Kollektor-Emitter-Strecke im Strompfad zwischen dem Schwellwertelement 44 und dem Masseanschluss 64 angeordnet. Liegt am Gruppenanschluss 50 ein Signal an, ist die Zener-Diode, die hier als Schwellwertelement 44 dient, mit der Masse am Anschluss 64 verbunden und am Punkt 67 stellt sich der entsprechende Schwellwert ein. Wird die Kollektor-Emitter-Strecke 76 hingegen getrennt, sodass es zu keinem Stromfluss durch die Leuchtdiode 70 im Optokoppler des ersten Koppelelements 42 kommen kann, ist das Schwellwertelement 44 deaktiviert. Durch Anlegen eines Steuersignals am Gruppenanschluss 50 kann somit das Detektionsvermögen durch das erste Koppelelement 42 und das Schwellwertelement 44 getestet werden.

Die Bezugsziffer 66 deutet hier einen Einspeiseanschluss an, über den weitere Schwellwertelemente 44 weiterer Eingänge mit der ersten Testeinrichtung 46 verbunden werden können. Auf diese Weise kann, wie im Folgenden an der Fig. 4 noch näher erläutert wird, eine Vielzahl von Eingängen mit einer einzelnen ersten Testeinrichtung 46 betrieben werden.

Die weitere Signalverarbeitung des Eingangssignals erfolgt im zweiten Schaltkreis (II). Der Kollektor auf der Sekundärseite 72 des Optokopplers 42 ist dazu mit einer Spannungsversorgung 65 verbunden, die der internen Versorgungsspannung der Sicherheitsschaltvorrichtung 10 entspricht, und der Emitter ist über eine zweite Testeinrichtung 52 mit einem Ausleiteschaltkreis 54 verbunden. Fließt ein Strom durch die Primärseite 70 des Optokopplers 42, fließt auch ein Strom von der Spannungsversorgung 65 zum Ausleiteschaltkreis 54. Ein Eingangssignal wird somit vom ersten Schaltkreis (I) zum zweiten (II) übertragen. Im Ausleiteschaltkreis 54 wird das Signal auf zwei Kanäle 55, 55' aufgeteilt und anschließend von einer Logikeinheit 35 weiterverarbeitet. Ab dem Ausleiteschaltkreis 54 wird das Eingangssignal folglich zweikanalig redundant weiterverarbeitet. Damit der eine Kanal 55' nicht auf den anderen Kanal 55 rückwirken kann, sind im Ausleiteschaltkreis 54 Trennelemente 58, 58' längs in jedem Kanal angeordnet. Eine zweikanalige Weiterverarbeitung kann beispielsweise durch einen zweiten Mikrokontroller 35' erfolgen.

Zwischen dem Koppelelement 42 und dem Ausleiteschaltkreis 54 ist die zweite Testeinrichtung 52 angeordnet. Die zweite Testeinrichtung 52 weist hier ein Schaltelement 68 auf, das in Strompfad zwischen der Sekundärseite 72 des Optokopplers und dem Ausleiteschaltkreis 54 angeordnet ist. Das Schaltelement 68 kann über ein Steuersignal am Einzeltestanschluss 56 betätigt werden, so dass der Strompfad wahlweise geschlossen und getrennt werden kann. In den bevorzugten Ausführungsbeispielen erzeugt die Logikeinheit 35 das Steuersignal am Einzeltestanschluss 56. Mit Hilfe der zweiten Testeinrichtung 52 werden Fehler in der zweikanaligen Signalverarbeitung, die dem Ausleiteschaltkreis 54 folgt, aufgedeckt, indem asynchron zur ersten Testeinrichtung 46 der Strompfad des Eingangssignals getrennt wird. Vorzugsweise erfolgt die Betätigung der zweiten Testeinrichtung 52 in größeren zeitlichen Abständen im Vergleich zur ersten Testeinrichtung 46, da durch die zweite Testeinrichtung 52 vor allem eine Fehlerhäufung aufgedeckt wird und somit auf Fehler geprüft wird, die nicht unmittelbar zu einem Verlust der Sicherheitsfunktion führen. In einer bevorzugten Ausführungsform ist der Testzyklus sehr viel größer als 200ms, wodurch die auswertende Logikeinheit 35, 35' geringer beansprucht wird.

Bezug nehmend auf die Fig. 4 wird im Folgenden näher erläutert, wie das Detektionsvermögen mehrerer Eingänge mit Hilfe des ersten Testelements 46 gleichzeitig bzw. in einem gemeinsamen Testzyklus überprüft werden kann. Fig. 4 zeigt hierzu das Ausführungsbeispiel aus Fig. 3 mit einem weiteren Eingang 30' zum Aufnehmen eines weitern Eingangssignal 38'.

Der zweite Eingang 30' verfügt über eine eigene Signaleingangsschaltung 40' mit EMV-Bauteilen 60' und eine Strombegrenzungseinrichtung 62'. Der zweite Eingang 30' ist ferner über ein zweites Koppelelement 42' wie zuvor beschrieben mit einem Ausleiteschaltkreis 54' verbunden. Am Ausleiteschaltkreis 54' wird das Eingangssignal 38' auf zwei Ausgangskanäle aufgeteilt und im Folgenden redundant weiterverarbeitet. Zwischen dem zweiten Koppelelement 42' und dem zweiten Ausleiteschaltkreis 54' ist eine zweite Testeinrichtung 52' angeordnet, über die redundante Schaltungsteile 35, 35' in zuvor beschriebener Weise überprüft werden können.

Das zweite Koppelelement 42' verfügt über ein zweites Schwellwertelement 44'. Die Schwellwertelemente 44, 44' des ersten und zweiten Eingangs 30, 30' sind über einen gemeinsamen Anschluss 66 mit der ersten Testeinrichtung 46 verbunden, wobei die erste Testeinrichtung 46 so ausgebildet ist, sowohl das erste Schwellwertelement 44 als auch das zweite Schwellwertelement 44' gezielt zu aktivieren und deaktivieren.

Zum Testen des Detektionsvermögen des ersten und des zweiten Eingangs 30, 30' ist somit nur eine Testeinrichtung 46 nötig, wodurch insbesondere zusätzliche Koppelelemente an den Eingängen 30, 30' eingespart werden können.

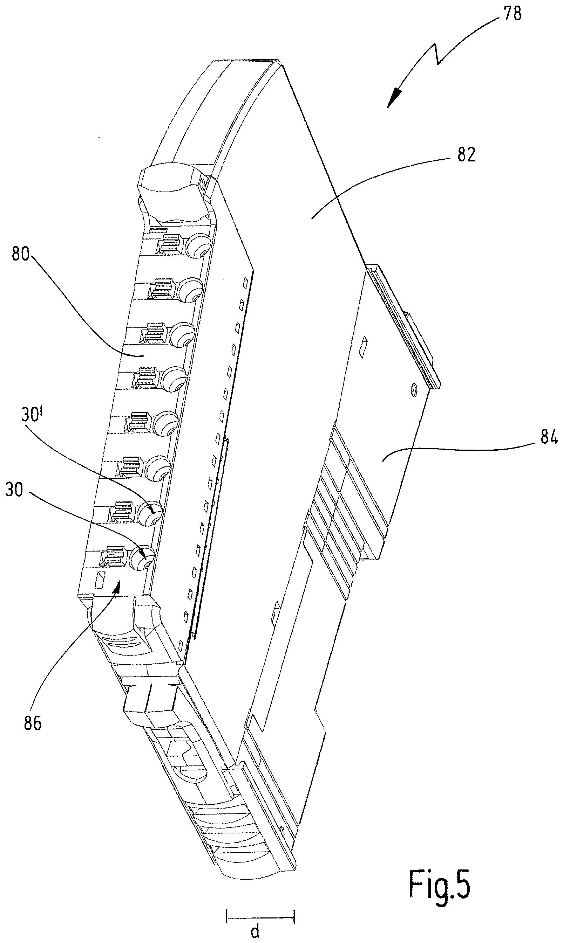

Fig. 5 zeigt an einem bevorzugten Ausführungsbeispiel, wie die neuen Eingänge in einem Eingangsmodul 78 der Sicherheitsschaltvorrichtung 10 zusammengefasst sein können.

Das Eingangsmodul 78 besteht hier aus drei, miteinander koppelbaren Modulteilen 80, 82, 84. Das erste Modulteil 80 ist ein Anschlussmodulteil mit Anschlussklemmen 86 zum Aufnehmen der Eingangssignale 38, 38'. Das zweite Modulteil 82 ist ein Logikmodul, in dem die Signalverarbeitung stattfindet und das dritte Modulteil 84 ist ein sogenanntes Backplanemodul, über das das Eingangsmodul 78 mit benachbarten Eingangsmodulen und/oder anderen Komponenten der Sicherheitsschaltvorrichtung verbindbar ist.

Das erste Modulteil 80 verfügt hier über eine Steckleiste mit insgesamt acht Anschlussklemmen 86 zum Aufnehmen von acht verschiedenen Eingangssignalen und weist darüberhinaus keine elektronischen Bauteile auf. Das Modulteil 80 dient lediglich der Aufnahme externer Eingangssignale und ist vorzugweise über eine Steckverbindung mit dem Logikmodulteil 82 gekoppelt, in welchem die Signalverarbeitung stattfindet. Durch die Trennung von Anschlussmodulteil und Logikmodulteil können insbesondere vorkonfigurierte Kabelbäume an das Eingangsmodul 78 angeschlossen werden, wodurch die Kopplung der Sicherheitsschaltvorrichtung 10 mit den Signalgebern 22 bzw. den Aktoren 16, 18 besonders einfach realisiert werden kann.

Das Logikmodulteil 82 umfasst die zuvor beschriebenen Eingangsschaltungen 32, die die Eingangssignale an den Anschlussklemmen des ersten Modulteils 80 auswerten. Die vorteilhafte, insbesondere platzsparende Ausgestaltung der Eingangsschaltungen 32 ermöglicht einen besonders schmalen Aufbau des Eingangsmoduls 78 in Hinblick auf die Modulbreite d. Im Logikmodul 82 ist ferner die Logikeinheit 35 angeordnet, die in Anhängigkeit der Eingangssignale ein oder mehrere Ausgangssignal zum Ansteuern einer technischen Anlage 12 erzeugt.

Die Ausgangssignale werden vorzugsweise über ein separates (hier nicht dargestelltes) Ausgangsmodul zu den jeweiligen Aktoren 16, 18, beispielsweise einem Schütz in der Stromversorgung 20 einer technischen Anlage 12, geführt. Die Signalübertragung von einem Eingangsmodul zu einem Ausgangsmodul wird hier durch das dritte Modulteil 84 wahrgenommen. Das dritte Modulteil 84 bildet zusammen mit weiteren, in einer Reihe angeordneten dritten Modulteilen eine sogenannte Backplane. Jedes dritte Modulteil 84 weist hierzu ein Buselement auf, welches mit dem Buselement des vorherigen und des folgenden dritten Modulteils verbunden ist, so dass zwischen den dritten Modulteilen eine Busstruktur zum Übertragen eines Datenbusses entsteht. Auf die dritten Modulteile werden die Logikmodule aufgesteckt und mit dem Datenbus gekoppelt, so dass die einzelnen Logikmodulteile über den Datenbus miteinander kommunizieren können.

Ein Ausgangssignal kann so von einem Eingangsmodul zu einem Ausgangsmodul übertragen werden. Alternativ können die Ausgänge aber auch direkt an dem Logikmodul angeordnet sein. Über spezielle Kommunikationsmodule ist es ferner möglich die Ausgangssignal auch zu anderen Sicherheitsschaltvorrichtungen zu übertragen und weiterzuverarbeiten, was insbesondere für die Steuerung von großen automatisierten Anlagen mit einer Vielzahl von einzelnen Anlagen vorteilhaft ist.

Insbesondere bei derart großen automatisierten Anlagen ist es zweckmäßig möglichst kleine Module für die Sicherheitsschaltvorrichtung bereitzustellen, wozu die vereinfachte Ausgestaltung der Eingangsschaltung vorteilhaft beiträgt.

## Patentansprüche

1. Sicherheitsschaltvorrichtung (10) zum fehlersicheren Abschalten einer technischen Anlage (12), mit einem ersten und mindestens einem zweiten Eingang (30, 30'),
wobei der erste Eingang (30) ein erstes Eingangssignal (38) mit einer ersten Eingangsschaltung (32) aufnimmt und der zweite Eingang (30') ein zweites Eingangssignal (38') mit einer zweiten Eingangsschaltung (32') aufnimmt,
wobei die erste und die zweite Eingangsschaltung (32, 32') in einen ersten (I) und einen zweiten Schaltkreis (II) unterteilt sind, die galvanisch voneinander getrennt sind,
wobei im ersten Schaltkreis (I) eine erste Signaleingangsschaltung (40), ein erstes Schwellwertelement (44) und ein erstens Koppelement (42) der ersten Eingangsschaltung (32) sowie eine zweite Signaleingangsschaltung (40'), ein zweites Schwellwertelement (44') und ein zweites Koppelelement (42') der zweiten Eingangsschaltung (32') angeordnet sind,
wobei der erste Schaltkreis (I) ferner eine erste Testeinrichtung (46) mit einem dritten Koppelelement (48) aufweist, wobei die erste Testeinrichtung (46) dazu ausgebildet ist, einen Strompfad vom ersten und zweiten Schwellwertelement (44, 44') zu einem Masseanschluss (68) zu unterbrechen,
wobei der zweite Schaltkreis (II) eine zweite Testeinrichtung (52) und einen ersten Ausleiteschaltkreis (54) des ersten Eingangs (30) und eine dritte Testeinrichtung (52') und einen zweiten Ausleiteschaltkreis (54') des zweiten Eingangs (30') aufweist, wobei der erste und zweite Ausleiteschaltkreis (54, 54') das jeweilige Eingangssignal (38, 38') für eine nachfolgende, zweikanalig redundante Signalverarbeitung auf zwei Kanäle aufteilen, und wobei das erste, zweite und dritte Koppelelement (42, 42', 48) den ersten und den zweiten Schaltkreis (I, II) miteinander verbinden.

2. Vorrichtung nach Anspruch 1, wobei die zweite Testeinrichtung (52) ein erstes Schaltelement (68) und die dritte Testeinrichtung (52') ein zweites Schaltelement (68') aufweist, wobei das erste Schaltelement (68) in einen Strompfad zwischen dem ersten Koppelelement (42) und dem ersten Ausleiteschaltkreis (54) angeordnet ist und das zweite Schaltelement (68') in einem Strompfad zwischen dem zweiten Koppelelement (42') und dem zweiten Ausleiteschaltkreis (54') angeordnet ist.

3. Vorrichtung nach einem der Ansprüche 1 oder 2, wobei die erste und zweite Signaleingangsschaltung (40, 40') EMV-Bauteile (60, 60') aufweisen, mit mindestens einer Spannungsbegrenzungseinrichtung, insbesondere einer Zener-Diode.

4. Vorrichtung nach einem der Ansprüche 1 bis 3, wobei die erste und zweite Signaleingangsschaltung (40, 40') Bauteile zur Strombegrenzung aufweisen, die einen Stromfluss in den erste und zweiten Eingangsschaltung (30, 30') begrenzen.

5. Vorrichtung nach einem der Ansprüche 1 bis 4, wobei die Ausleiteschaltkreise (54, 54') zum Unterdrücken von Rückwirkungen für jeden Kanal Trennelemente (58, 58') aufweisen.

6. Vorrichtung nach Anspruch 5, wobei die zwei Kanäle der nachfolgenden Signalverarbeitung unterschiedlich ausgebildet sind.

7. Vorrichtung nach einem der Ansprüche 1 bis 6, wobei die erste Testeinrichtung (46) asynchron zur zweiten und dritten Testeinrichtung (52, 52') arbeitet.

8. Vorrichtung nach einem der Ansprüche 1 bis 7, wobei das erste und das zweite Schwellwertelement (44) redundant ausgelegt sind, insbesondere mit zwei Zener-Dioden.

9. Vorrichtung nach einem der Ansprüche 1 bis 8, wobei zur Filterung von langsamen Störsignalen nach dem ersten und zweiten Ausleiteschaltkreis (54, 54') eine Logikeinheit (35) mit Filterelementen angeordnet ist.

10. Verfahren zum fehlersicheren Einlesen von binären Zuständen an einem ersten und mindestens einem zweiten Eingang (30, 30') einer Sicherheitsschaltvorrichtung (10), mit den Schritten:
- Aufnehmen eines ersten Eingangssignals (38) mit einer ersten Eingangsschaltung (32) an einem ersten Eingang (30), und
- Aufnehmen eines zweiten Eingangssignals (38') mit einer zweiten Eingangsschaltung (32') an einem zweiten Eingang (30'),
wobei die erste und die zweite Eingangsschaltung (32, 32') in einen ersten (I) und einen zweiten Schaltkreis (II) unterteilt sind, die galvanisch voneinander getrennt sind, wobei im ersten Schaltkreis (I) eine erste Signaleingangsschaltung (40), ein erstes Schwellwertelement (44) und ein erstens Koppelement (42) der ersten Eingangsschaltung (32) sowie eine zweite Signaleingangsschaltung (40'), ein zweites Schwellwertelement (44') und ein zweites Koppelelement (42') der zweiten Eingangsschaltung (32') angeordnet sind, wobei der erste Schaltkreis (I) ferner eine erste Testeinrichtung (46) mit einem dritten Koppelelement (48) aufweist, wobei die erste Testeinrichtung (46) dazu ausgebildet ist, einen Strompfad vom ersten und zweiten Schwellwertelement zu einem Masseanschluss (68) zu unterbrechen, wobei der zweite Schaltkreis (II) eine zweite Testeinrichtung (52) und einen ersten Ausleiteschaltkreis (54) des ersten Eingangs (30) und eine dritte Testeinrichtung (52') und einen zweiten Ausleiteschaltkreis (54') des zweiten Eingangs (30') aufweist, wobei der erste und zweite Ausleiteschaltkreis (54, 54') das jeweilige Eingangssignal (38, 38') für eine nachfolgende, zweikanalig redundante Signalverarbeitung auf zwei Kanäle aufteilen,
und wobei das erste, zweite und dritte Koppelelement (42, 42', 48) den ersten und den zweiten Schaltkreis (I, II) miteinander verbinden.

## Claims

1. Safety switching device (10) for fail-safe shutdown of a technical installation (12), having a first and at least one second input (30, 30'),
wherein the first input (30) receives a first input signal (38) with a first input circuit (32) and the second input (30') receiving a second input signal (38') with a second input circuit (32'),
wherein the first and second input circuits (32, 32') are divided into a first (I) and a second circuit (II) which are galvanically isolated from each other,
wherein a first signal input circuit (40), a first threshold value element (44), a first coupling element (42) of the first input circuit (32), a second signal input circuit (40'), a second threshold value element (44'), and a second coupling element (42') of the second input circuit (32') are arranged in the first circuit (I),
wherein the first circuit (I) further comprises a first testing means (46) having a third coupling element (48), wherein the first testing means (46) is configured to interrupt a current path from the first and second threshold elements (44, 44') to a ground terminal (68),
wherein a second testing means (52) and a first output circuit (54) of the first input (30), a third testing means (52'), and a second output circuit (54') of the second input (30') are arranged in the second circuit (II), wherein the first and second output circuits (54, 54') divide the respective input signal (38, 38') into two channels for subsequent two-channel redundant signal processing,
and wherein the first, second and third coupling elements (42, 42', 48) interconnect the first and second circuit (I, II).

2. The device according to claim 1, wherein the second testing means (52) comprises a first switching element (68) and the third testing means (52') comprises a second switching element (68'), wherein the first switching element (68) is arranged in a current path between the first coupling element (42) and the first output circuit (54) and the second switching element (68') is arranged in a current path between the second coupling element (42') and the second output circuit (54').

3. The device according to any one of claims 1 or 2, wherein the first and second signal input circuits (40, 40') have EMC components (60, 60') with at least one voltage limiting device, in particular a Zener diode.

4. The device according to any one of claims 1 to 3, wherein the first and second signal input circuits (40, 40') comprise current limiting components which limit a current flow into the first and second input circuits (30, 30').

5. The device according to any one of claims 1 to 4, wherein the output circuits (54, 54') comprise separator elements (58, 58') for each channel to suppress feedback.

6. The device according to claim 5, wherein the two channels of the subsequent signal processing are formed differently.

7. The device according to any one of claims 1 to 6, wherein the first testing means (46) operates asynchronously with respect to the second and third testing means (52, 52').

8. The device according to any one of claims 1 to 7, wherein the first and the second threshold value element (44) are designed redundantly, in particular having two Zener diodes.

9. The device according to one of claims 1 to 8, wherein a logic unit (35) with filter elements is arranged after the first and second output circuits (54, 54') for filtering slow interference signals.

10. Method for fail-safe reading of binary states at a first and at least one second input (30, 30') of a safety switching device (10), having the steps:
- Receiving a first input signal (38) with a first input circuit (32) at a first input (30), and
- Receiving a second input signal (38') with a second input circuit (32') at a second input (30'),
wherein the first and second input circuits (32, 32') are divided into a first circuit (I) and a second circuit (II) that are galvanically isolated from one another, wherein a first signal input circuit (40), a first threshold value element (44), a first coupling element (42) of the first input circuit (32), a second signal input circuit (40'), a second threshold element (44'), and a second coupling element (42') of the second input circuit (32') are arranged in the first circuit (I), wherein the first circuit (I) further comprises a first testing means (46) having a third coupling element (48), wherein the first test means (46) is configured to interrupt a current path from the first and second threshold elements to a ground terminal (68), wherein a second testing means (52), a first output circuit (54) of the first input (30), a third testing means (52'), and a second output circuit (54') of the second input (30') are arranged in the second circuit (II), wherein the first and second output circuits (54, 54') divide the respective input signal (38, 38') into two channels for subsequent two-channel redundant signal processing, and wherein the first, second and third coupling elements (42, 42', 48) interconnect the first and second circuit (I, II).

## Revendications

1. Dispositif de commutation de sécurité (10) pour déconnecter une installation technique (12) de manière protégée contre les erreurs, comprenant une première et au moins une deuxième entrée (30, 30'),
dans lequel la première entrée (30) reçoit un premier signal d'entrée (38) au moyen d'un premier circuit d'entrée (32) et la deuxième entrée (30') reçoit un deuxième signal d'entrée (38') au moyen d'un deuxième circuit d'entrée (32'),
dans lequel les premier et deuxième circuits d'entrée (32, 32') sont subdivisés en un premier (I) et un deuxième circuit de commutation (II) qui sont galvaniquement séparés l'un de l'autre,
dans lequel un premier circuit d'entrée de signal (40), un premier élément de valeur de seuil (44) et un premier élément de couplage (42) du premier circuit d'entrée (32) ainsi qu'un deuxième circuit d'entrée de signal (40'), un deuxième élément de valeur de seuil (44') et un deuxième élément de couplage (42') du deuxième circuit d'entrée (32') sont disposés dans le premier circuit de commutation (I),
dans lequel le premier circuit de commutation (I) comporte en outre un premier dispositif de test (46) muni d'un troisième élément de couplage (48), dans lequel le premier dispositif de test (46) est conçu pour interrompre un trajet de courant des premier et deuxième éléments de valeur de seuil (44, 44') à une borne de masse (68),
dans lequel le deuxième circuit de commutation (II) comporte un deuxième dispositif de test (52) et un premier circuit de commutation de sortie (54) de la première entrée (30) et un troisième dispositif de test (52') et un deuxième circuit de commutation de sortie (54') de la deuxième entrée (30'), dans lequel les premier et deuxième circuits de commutation de sortie (54, 54') subdivisent le signal d'entrée respectif (38, 38') en deux canaux pour un traitement de signal redondant sur deux canaux effectué ensuite,
et dans lequel les premier, deuxième et troisième éléments de couplage (42, 42', 48) relient entre eux les premier et deuxième circuits de commutation (I, II).

2. Dispositif selon la revendication 1, dans lequel le deuxième dispositif de test (52) comporte un premier élément de commutation (68) et le troisième dispositif de test (52') comporte un deuxième élément de commutation (68'), dans lequel le premier élément de commutation (68) est disposé dans un trajet de courant entre le premier élément de couplage (42) et le premier circuit de commutation de sortie (54), et le deuxième élément de commutation (68') est disposé dans un trajet de courant entre le deuxième élément de couplage (42') et le deuxième circuit de commutation de sortie (54').

3. Dispositif selon l'une des revendications 1 ou 2, dans lequel les premier et deuxième circuits d'entrée de signal (40, 40') comportent des composants CEM (60, 60') munis d'au moins un dispositif de limitation de tension, en particulier d'une diode Zener.

4. Dispositif selon l'une des revendications 1 à 3, dans lequel les premier et deuxième circuits d'entrée de signal (40, 40') comportent des composants de limitation de courant qui limitent un flux de courant dans les premier et deuxième circuits d'entrée (30, 30').

5. Dispositif selon l'une des revendications 1 à 4, dans lequel les circuits de commutation de sortie (54, 54') comportent des éléments de séparation (58, 58') pour supprimer des rétroactions pour chaque canal.

6. Dispositif selon la revendication 5, dans lequel les deux canaux du traitement de signal effectué ensuite sont réalisés différemment.

7. Dispositif selon l'une des revendications 1 à 6, dans lequel le premier dispositif de test (46) fonctionne de manière asynchrone par rapport aux deuxième et troisième dispositifs de test (52, 52').

8. Dispositif selon l'une des revendications 1 à 7, dans lequel les premier et deuxième éléments de valeur de seuil (44) sont conçus de manière redondante, en particulier avec deux diodes Zener.

9. Dispositif selon l'une des revendications 1 à 8, dans lequel une unité logique (35) comportant des éléments filtrants est disposée en aval des premier et deuxième circuits de commutation de sortie (54, 54') pour le filtrage de signaux parasites lents.

10. Procédé de lecture protégée contre les erreurs d'états binaires sur une première et au moins une deuxième entrée (30, 30') d'un dispositif de commutation de sécurité (10), comprenant les étapes suivantes :
- recevoir un premier signal d'entrée (38) au moyen d'un premier circuit d'entrée (32) sur une première entrée (30), et
- recevoir un deuxième signal d'entrée (38') au moyen d'un deuxième circuit d'entrée (32') sur une deuxième entrée (30'),
dans lequel les premier et deuxième circuits d'entrée (32, 32') sont subdivisés en un premier (I) et un deuxième circuit (II) qui sont galvaniquement séparés l'un de l'autre, dans lequel un premier circuit d'entrée de signal (40), un premier élément de valeur de seuil (44) et un premier élément de couplage (42) du premier circuit d'entrée (32) ainsi qu'un deuxième circuit d'entrée de signal (40'), un deuxième élément de valeur de seuil (44') et un deuxième élément de couplage (42') du deuxième circuit d'entrée (32') sont disposés dans le premier circuit (I), dans lequel le premier circuit (I) comprend en outre un premier dispositif de test (46) comportant un troisième élément de couplage (48), dans lequel le premier dispositif de test (46) est conçu pour interrompre un trajet de courant des premier et deuxième éléments de valeur de seuil à une borne de masse (68),
dans lequel le deuxième circuit de commutation (II) comprend un deuxième dispositif de test (52) et un premier circuit de commutation de sortie (54) de la première entrée (30) et un troisième dispositif de test (52') et un deuxième circuit de commutation de sortie (54') de la deuxième entrée (30'), dans lequel les premier et deuxième circuits de commutation de sortie (54, 54') subdivisent le signal d'entrée respectif (38, 38') en deux canaux pour un traitement de signal redondant sur deux canaux effectué ensuite,
et dans lequel les premier, deuxième et troisième éléments de couplage (42, 42', 48) relient entre eux les premier et deuxième circuits de commutation (I, II).
